# EUROPEAN PATENT SPECIFICATION

(11) **EP 2 293 093 B1**
(45) Date of publication and mention of the grant of the patent: **26.08.2015**
(21) Application number: 09754752.5
(22) Date of filing: 28.05.2009
(51) Int. Cl.: G01R 33/09, G01D 5/245, H01L 43/08, G01D 5/14, B82Y 25/00

(54) **MAGNETIC SENSOR AND MAGNETIC ENCODER**
MAGNETSENSOR UND MAGNETCODIERER
CAPTEUR MAGNÉTIQUE ET CODEUR MAGNÉTIQUE

(30) Priority: 30.05.2008 JP 2008142043
(43) Date of publication of application: 09.03.2011
(73) Proprietor: Alps Electric Co., Ltd., Tokyo 145-8501 (JP)
(72) Inventor: SUGIHARA, Shinji, Tokyo 145-8501 (JP); ANDO, Hideto, Tokyo 145-8501 (JP); ASATSUMA, Kota, Tokyo 145-8501 (JP)
(74) Representative: Klunker . Schmitt-Nilson . Hirsch
(86) International application number: PCT/JP2009/059739
(87) International publication number: WO 2009/145244

(56) References cited:
- JP-A- 5 281 319
- JP-A- H05 281 319
- JP-A- 2004 014 610
- JP-A- 2004 014 610
- JP-A- 2007 199 007
- JP-A- 2007 199 007
- US-A1- 2003 203 238

## Description

### Technical Field

The present invention relates to a magnetic sensor and a magnetic encoder having a satisfactory magnetic sensitivity to an external magnetic field in a sensitivity axis direction and an improved disturbance resistance against a magnetic field in a direction other than the sensitivity axis direction.

### Background Art

A magnetic sensor including a giant magnetoresistive effect element (GMR element) is mounted in, for example, a magnetic encoder. The GMR element has a layered structure in which a pinned magnetic layer and a free magnetic layer are stacked with a non-magnetic layer interposed therebetween. In the pinned magnetic layer, a direction of magnetization is pinned in a certain direction. In the free magnetic layer, magnetization is not pinned but is varied in accordance with an external magnetic field applied by a magnet included in the magnetic encoder.

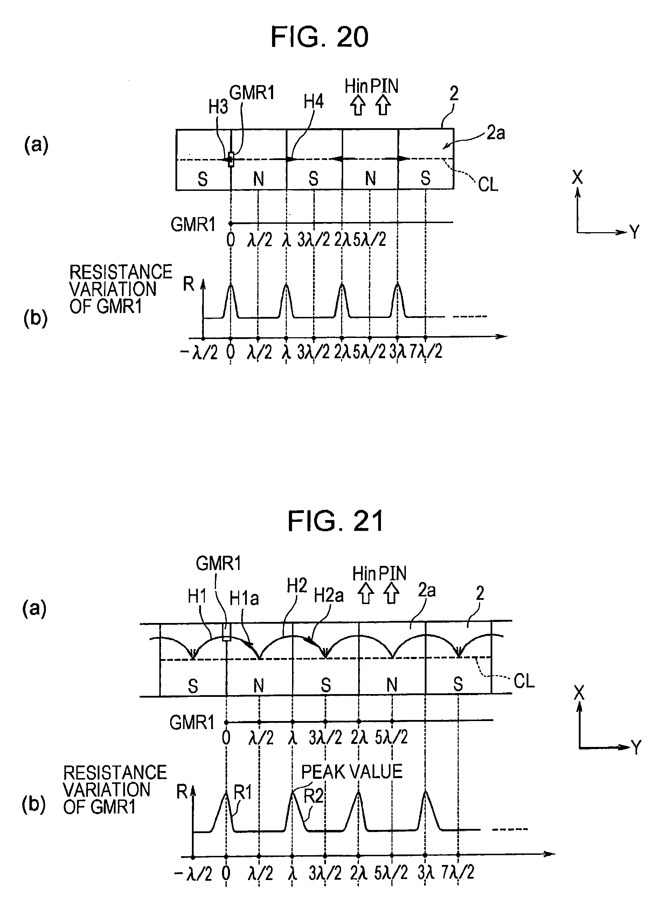

Fig. 20(a) is a plan view illustrating the state in which a GMR element 1 is placed above a magnetized surface 2a of a magnet 2 at a center CL of the magnetized surface 2a in the width direction thereof. A pinned magnetization direction (PIN direction) of a pinned magnetic layer included in the GMR element 1 is an X direction, as illustrated in Fig. 20(a). An interlayer bias magnetic field Hin is generated between the pinned magnetic layer and a free magnetic layer included in the GMR element 1 in, for example, the X direction.

The position of the GMR element 1 illustrated in Fig. 20(a) is defined as an initial position (0). The GMR element 1 relatively moves in a Y direction illustrated in the figure. Positions of the GMR element 1 relative to the initial position (0) thereof are denoted by λ/2, λ, 3λ/2, ..., in the lower section of Fig. 20(a). Here, λ is the is the center-to-center distance between N and S poles of the magnet 2.

In the state in which no external magnetic field is applied by the magnet 2 (magnetic-field-free state), the magnetization direction of the free magnetic layer in the GMR element 1 is the X direction, which is the same as the magnetization direction PIN of the pinned magnetic layer, owing to the interlayer bias magnetic field Hin. Therefore, the resistance of the GMR element 1 is at a minimum. When the GMR element 1 is positioned above the center of one of the N and S poles, the GMR element 1 is in the magnetic-field-free state and the resistance thereof is at a minimum. When the GMR element 1 relatively moves from an S pole to an N pole or from an N pole to an S pole, a horizontal magnetic-field component H3 or H4 in a direction parallel to the Y direction illustrated in Fig. 20(a) is applied to the GMR element 1. The "horizontal magnetic-field component" is an external magnetic field that is applied along a plane parallel to interfaces between the layers in the layered structure of the GMR element. Fig. 20(b) illustrates the resistance variation along the direction of relative movement of the GMR element 1 from the initial position (0).

As is clear from Fig. 20(b), the waveform of each of the waves of the resistance of the GMR element 1 is horizontally symmetrical with respect to a peak position, and all of the waves of resistance have the same shape.

In general, the magnetic sensor mounted in the magnetic encoder includes a plurality of GMR elements. The GMR elements are arranged with predetermined intervals therebetween in the Y direction using the center-to-center distance λ between the N and S poles of the magnet as a reference. An output waveform (voltage variation) is obtained on the basis of the resistance variation of each GMR element.

In the case where the GMR elements relatively move in the Y direction along the center CL of the magnetized surface 2a of the magnet 2 in the width direction thereof, no particular problem occurs since waves in the output waveform are horizontally symmetrical.

However, it has been found that, when the GMR elements are displaced in the width direction from the center of the magnetized surface of the magnet in the width direction thereof, the output waveform is deformed.

In Fig. 21(a), the GMR element 1 is displaced in the width direction (X direction in the figure) from the center CL of the magnetized surface 2a of the magnet 2 in the width direction (X direction in the figure).

Fig. 21(a) illustrates horizontal magnetic-field components (magnetic lines of force) H1 and H2 of the external magnetic field H generated between the N and S poles of the magnetized surface 2a. The horizontal magnetic-field components H1 and H2 are major components that affect the interlayer bias magnetic field Hin in the GMR element 1.

Fig. 21(b) illustrates the resistance variation along the direction of relative movement of the GMR element 1 from the initial position (0). As is clear from Fig. 21(b), the waveform of each of the waves of the resistance of the GMR element 1 is not horizontally symmetrical with respect to a peak position, but is deformed.

When the GMR element 1 relatively moves in the Y direction from the initial position (0), a horizontal magnetic-field component H1a in the horizontal magnetic-field component H1 enters the GMR element 1, the direction of the horizontal magnetic-field component H1a being close to the X direction. Therefore, the interlayer bias magnetic field Hin generated in the GMR element 1 in the X direction is greater than it seems, and the free magnetic layer is more easily magnetized in the X direction. Therefore, as illustrated in Fig. 21(b), a resistance variation R1 that occurs when the GMR element 1 moves from above a boundary between the poles to above an N-pole is steep with respect to the direction of relative movement. In contrast, when the GMR element 1 relatively moves by λ from the initial position (0) and then relatively moves further in the Y direction, a horizontal magnetic-field component H2a in the horizontal magnetic-field component H2 enters the GMR element 1, the direction of the horizontal magnetic-field component H2a being close to the direction opposite to X direction. Therefore, the interlayer bias magnetic field Hin generated in the GMR element 1 in the X direction is smaller than it seems, and the free magnetic layer is not easily magnetized in the X direction. Therefore, as illustrated in Fig. 21(b), a resistance variation R2 that occurs when the GMR element 1 moves from above a boundary between the poles to above an S-pole is gentler than the resistance variation R1 with respect to the direction of relative movement. Similarly, a resistance variation that occurs when the GMR element 1 moves from above an S-pole to above a boundary between the poles differs from a resistance variation that occurs when the GMR element 1 moves from above an N-pole to above a boundary between the poles.

Since the resistance variation in the GMR element is deformed as described above, the output waveform (voltage variation) generated on the basis of the resistance variation is also deformed. Therefore, a movement speed, a movement distance, etc., cannot be accurately detected, and the detection accuracy is reduced.

This problem of the related art is not mentioned in Patent Documents 1 to 3, and means for solving the problem is, of course, not proposed.
Cited Document 1: Japanese Unexamined Patent Application Publication No. 2002-319112.
Cited Document 2: Japanese Unexamined Patent Application Publication No. 2002-53956.
Cited Document 3: Japanese Unexamined Patent Application Publication No. 2004-14610.

### Disclosure of Invention

### Problems to be Solved by the Invention

The present invention has been made to solve the above-described problem. In particular, an object of the present invention is to provide a magnetic sensor and a magnetic encoder having a satisfactory magnetic sensitivity to an external magnetic field in a sensitivity axis direction and an improved disturbance resistance against a magnetic field in a direction other than the sensitivity axis direction.

### Means for Solving the Problems

A magnetic sensor according to the present invention includes a magnetic detection element having an electrical resistance value that varies in accordance with an external magnetic field in a sensitivity axis direction.

The magnetic detection element includes an element portion having a layered structure in which a first magnetic layer and a second magnetic layer are stacked with a non-magnetic layer interposed therebetween.

Magnetization of each of the first magnetic layer and the second magnetic layer is variable in accordance with the external magnetic field.

In a magnetic-field-free state, a magnetization direction of the first magnetic layer is inclined from an element width direction that is perpendicular to the sensitivity axis direction toward a first direction along the sensitivity axis direction and a magnetization direction of the second magnetic layer is inclined from the element width direction toward a second direction that is opposite to the first direction along the sensitivity axis direction, an angle between the magnetization direction of the first magnetic layer and the magnetization direction of the second magnetic layer being in the range of 90 degrees to 180 degrees.

The element portion has an oblong shape, a longitudinal direction of the element portion being the sensitivity axis direction. Accordingly, a satisfactory magnetic sensitivity to an external magnetic field in the sensitivity axis direction can be provided, and a disturbance resistance against a magnetic field in a direction other than the sensitivity axis direction can be improved.

In the present invention, preferably, the magnetization direction of the first magnetic layer and the magnetization direction of the second magnetic layer are substantially antiparallel to each other along the sensitivity axis direction.

In addition, in the present invention, preferably, a ratio between Ms1·t1 (Ms is a saturation magnetization and t is a layer thickness) of the first magnetic layer and Ms2·t2 of the second magnetic layer (Ms2·t2/Ms1·t1) is greater than 1 and smaller than 2.

In addition, in the present invention, preferably, each of the first magnetic layer and the second magnetic layer has a layered structure including a Co-Fe layer and a Ni-Fe layer, and the Co-Fe layers of the first and second magnetic layers are opposed to each other with the non-magnetic layer interposed therebetween.

In addition, in the present invention, preferably, the magnetic detection element includes a plurality of the element portions that are arranged with intervals therebetween in a direction perpendicular to the sensitivity axis direction, the element portions being shaped so as to be connected to each other at the ends of the element portions in the sensitivity axis direction.

A magnetic encoder according to the present invention includes the above-described magnetic sensor and a magnetic-field generating member having a magnetized surface including sections that are alternately magnetized to N and S poles along a relative movement direction, which is the sensitivity axis direction. The magnetic sensor is disposed at a position spaced from the magnetized surface in a height direction. Accordingly, even when the magnetic sensor is displaced from the center of the magnetized surface of the magnetic-field generating member in the width direction thereof, a satisfactory magnetic sensitivity to the magnetic-field component in the sensitivity axis direction and a satisfactory disturbance resistance against a magnetic-field component in a direction perpendicular to the sensitivity axis direction (disturbance magnetic-field component) can be provided. As a result, the detection accuracy can be increased compared to that of the related art.

### Advantages

The magnetic sensor according to the present invention has a satisfactory magnetic sensitivity to an external magnetic field in a sensitivity axis direction and an improved disturbance resistance against a magnetic field in a direction other than the sensitivity axis direction. Best Modes for Carrying Out the Invention

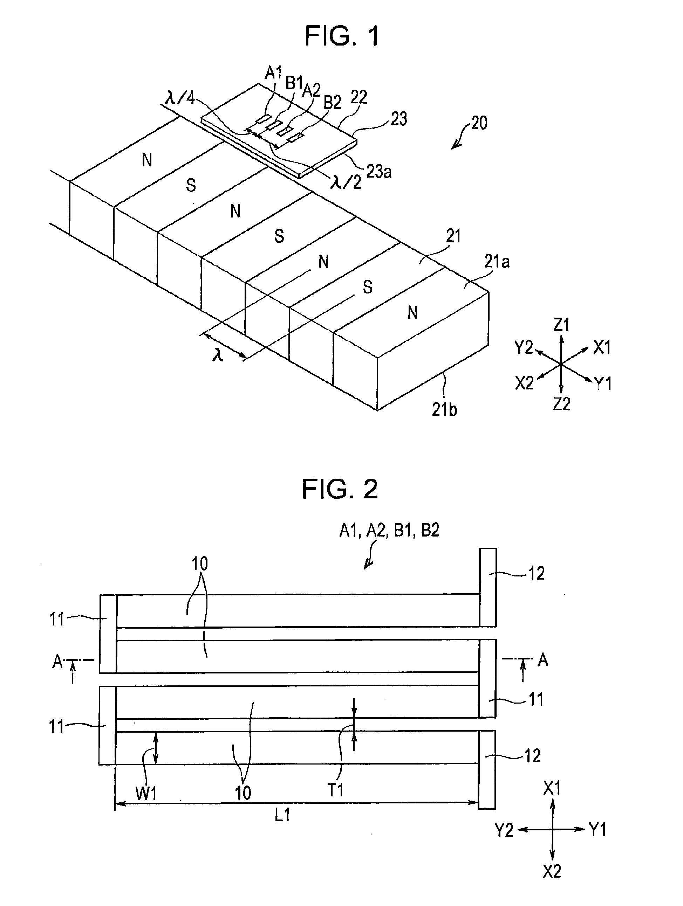

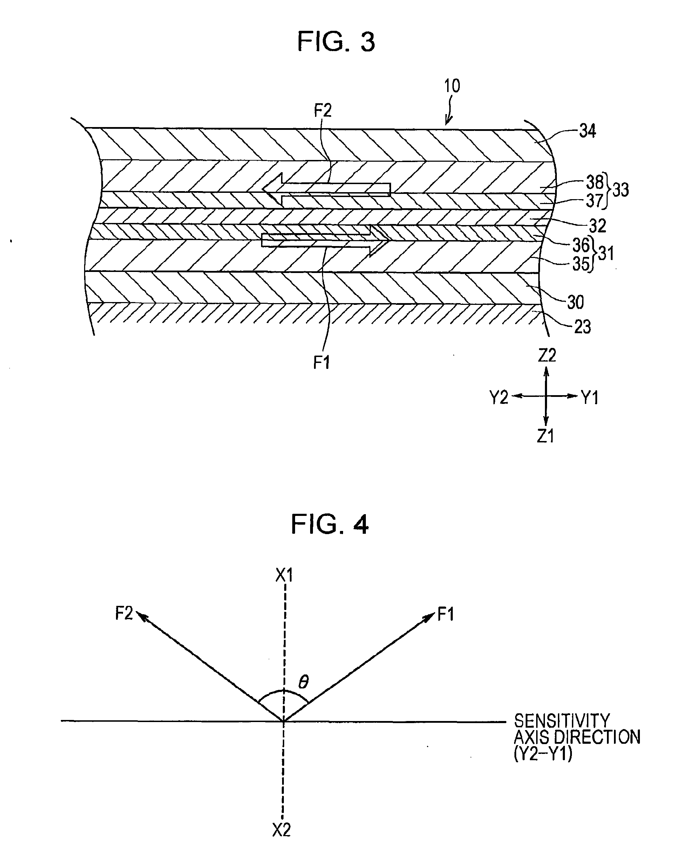

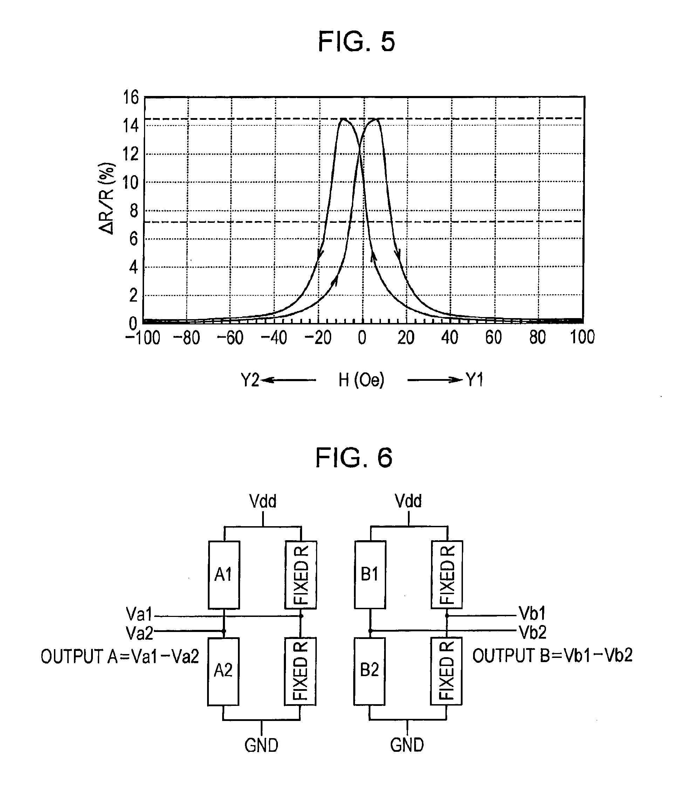

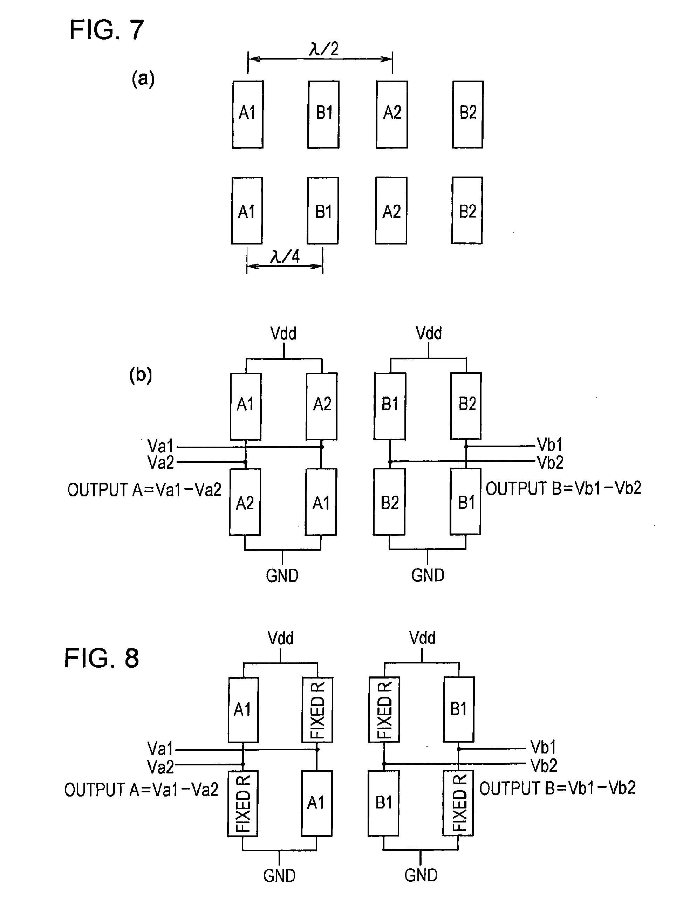

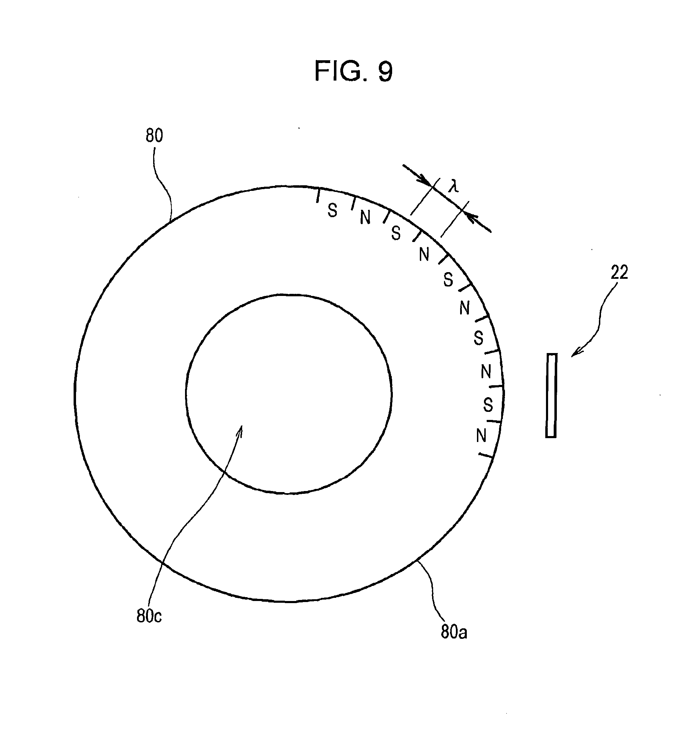

Fig. 1 is a partial perspective view of a magnetic encoder according to the present embodiment. Fig. 2 is an enlarged plan view of a magnetic detection element included in a magnetic sensor. Fig. 3 is a partial enlarged sectional view of the magnetic detection element illustrated in Fig. 2 taken along line A-A and viewed in a direction shown by the arrows. Fig. 4 is a schematic plan view illustrating the relationship between magnetization of a first magnetic layer and magnetization of a second magnetic layer. Fig. 5 is a graph illustrating the relationship between the external magnetic field in the sensitivity axis direction and the resistance variation rate (ΔR/R) in the magnetic detection element according to the present embodiment. Fig. 6 is a circuit diagram of the magnetic sensor according to the present embodiment. Fig. 7(a) is a diagram illustrating the arrangement of magnetic detection elements that differs from the arrangement in Fig. 1, and Fig. 7(b) is a circuit diagram of a circuit including the magnetic detection elements illustrated in Fig. 7(a). Fig. 8 is a circuit diagram of a magnetic sensor according to the present embodiment that differs from the magnetic sensor illustrated in Figs. 6 and 7. Fig. 9 is a partial side view of a magnetic encoder according to the present embodiment having a structure that differs from the structure illustrated in Fig. 1.

In each figure, each of the X1-X2 direction, the Y1-Y2 direction, and the Z1-Z2 direction is perpendicular to the other two directions. The Y1-Y2 direction is a relative movement direction in which the magnet and the magnetic sensor move relative to each other. The Z1-Z2 direction is a height direction in which the magnet and the magnetic sensor face each other with a predetermined gap therebetween.

Referring to Fig. 1, a magnetic encoder 20 includes a magnet 21 and a magnetic sensor 22.

The magnet 21 is rod-shaped and extends in the Y1-Y2 direction. A top surface 21a of the magnet 21 is a magnetized surface including sections that have a predetermined width in the Y1-Y2 direction and that are alternately magnetized to N and S poles. The N and S poles are arranged at constant intervals, and the center-to-center distance (pitch) between the N and S poles is λ. A bottom surface 21b of the magnet 21 is a magnetized surface including sections that are magnetized to poles opposite to the poles on the top surface 21a (not shown).

The magnetic sensor 22 is disposed above the top surface 21a of the magnet 21 with a predetermined space therebetween.

As illustrated in Fig. 1, the magnetic sensor 22 includes a substrate 23 and a plurality of magnetic detection elements A1, A2, B1, and B2 provided on a surface (surface facing the magnet 21) 23a of the common substrate 23.

As illustrated in Fig. 1, the magnetic detection elements A1, A2, B1, and B2 are arranged in the Y1-Y2 direction at constant intervals of λ/4. Referring to the circuit diagram of Fig. 6, the magnetic detection element A1 and the magnetic detection element A2 are connected in series, and the magnetic detection element B1 and the magnetic detection element B2 are connected in series. Each pair of magnetic detection elements that are connected in series are spaced from each other by λ/2 in the Y1-Y2 direction.

As illustrated in Fig. 2, each of the magnetic detection elements A1, A2, B1, and B2 includes band-shaped element portions 10 that extend in the Y1-Y2 direction. An element width of each element portion 10 in the X1-X2 direction is W1, and a length of each element portion 10 in the Y1-Y2 direction is L1. As is clear from Fig. 2, the length L1 is greater than the element width W1. Thus, each element portion 10 has an oblong shape that extends in the Y1-Y2 direction.

As illustrated in Fig. 2, a plurality of element portions 10 are provided, and the element portions 10 are arranged in the X1-X2 direction with predetermined intervals T1 therebetween.

As illustrated in Fig. 2, the element portions 10 are connected to each other by connecting portions 11 at the ends thereof in the Y1-Y2 direction. The connecting portions 11 may be formed of an electrode layer made of a non-magnetic conductive material or a hard bias layer. Each of the magnetic detection elements A1, A2, B1, and B2 has a meander shape formed of the element portions 10 and the connecting portions 11. The connecting portions 11 may be formed in the same layer structure as that of the element portions 10, and be formed integrally with the element portions 10 in the layer structure to form the meander shape. Even when the connecting portions 11 are formed in the same layer structure as that of the element portions 10, the length L1 of the element portions 10 is defined as the length of the portions excluding the connecting portions 11 (length equal to the length L1 in Fig. 2).

As illustrated in Fig. 2, wiring portions 12 made of a non-magnetic conductive material are connected to ends of the element portions 10 that are positioned at the ends in the X1-X2 direction.

Each element portion 10 has a layered structured illustrated in Fig. 3. Referring to Fig. 3, each element portion 10 includes a seed layer 30, a first magnetic layer 31, a non-magnetic layer 32, a second magnetic layer 33, and a protecting layer 34 in that order from the bottom. The seed layer 30 is formed of, for example, NiFeCr or Cr. The seed layer 30 is provided to align the crystalline orientations of the layers formed on the seed layer 30. However, the seed layer 30 may be omitted. A non-magnetic underlying layer formed of Ta or the like may be formed under the seed layer 30. In the case where the seed layer 30 is omitted, the first magnetic layer 31 is preferably formed on the substrate 23 with the underlying layer provided therebetween.

The first magnetic layer 31 includes a Ni-Fe layer 35 and a Co-Fe layer 36 in that order from the bottom.

The non-magnetic layer 32 is preferably formed of an alloy containing one or more of Cu, Ru, Rh, Ir, Cr, and Re.

The second magnetic layer 33 includes a Co-Fe layer 37 and a Ni-Fe layer 38 in that order from the bottom.

The protecting layer 34 is formed of, for example, Ta. Although it is not essential to form the protecting layer 34, the protecting layer 34 is preferably formed.

Referring to Fig. 3, the first magnetic layer 31 and the second magnetic layer 33 are stacked with the non-magnetic layer 32 interposed therebetween. The first magnetic layer 31 and the second magnetic layer 33 have layered structures including the Co-Fe layers 36 and 37, respectively, and the Ni-Fe layers 35 and 38, respectively. As illustrated in Fig. 3, the Co-Fe layer 36 included in the first magnetic layer 31 and the Co-Fe layer 37 included in the second magnetic layer 33 are opposed to each other with the non-magnetic layer 32 interposed therebetween.

The first magnetic layer 31 and the second magnetic layer 33 are preferably formed of the same magnetic material. In such a case, Ms·t (Ms is the saturation magnetization and t is the layer thickness) of the first magnetic layer 31 and the second magnetic layer 33, which will be described below, can be easily adjusted.

The first magnetic layer 31 and the second magnetic layer 33 may be formed of materials other than Ni-Fe and Co-Fe. In addition, each of the magnetic layers 31 and 33 may either have a single-layer structure or a multilayer structure.

However, preferably, the magnetic layers 31 and 33 have layered structures including the Ni-Fe layers 35 and 38, respectively, and the Co-Fe layers 36 and 37, respectively, and the Co-Fe layers 36 and 37 are opposed to each other with the non-magnetic layer 32 interposed therebetween, as illustrated in Fig. 3. In such a case, NiFe can be prevented from diffusing into the non-magnetic layer 32 when heat is applied.

Magnetization of each of the first magnetic layer 31 and the second magnetic layer 33 is variable in accordance with the external magnetic field. In other words, unlike the pinned magnetic layer in the GMR element, the magnetization is not pinned.

In the present embodiment, the Y1-Y2 direction serves as the sensitivity axis direction of the magnetic detection elements A1, A2, B1, and B2.

Referring to Fig. 4, in the magnetic-field-free state (state in which no external magnetic field is applied), a magnetization direction F1 of the first magnetic layer 31 is inclined from an element width direction (X1-X2 direction) that is perpendicular to the sensitivity axis direction (Y1-Y2 direction) toward the Y1 direction (first direction). In addition, a magnetization direction F2 of the second magnetic layer 33 is inclined from the element width direction (X1-X2 direction) toward the Y2 direction (second direction). An angle θ between the magnetization direction F1 of the first magnetic layer 31 and the magnetization direction F2 of the second magnetic layer 33 is in the range of 90 degrees to 180 degrees.

As illustrated in Fig. 3, in the present embodiment, the magnetization direction F1 of the first magnetic layer 31 and the magnetization direction F2 of the second magnetic layer 33 are preferably substantially antiparallel to each other along the sensitivity axis direction (Y1-Y2 direction) in the magnetic-field-free state.

Here, "substantially antiparallel" means the state in which the angle θ (obtuse angle) between the magnetization direction F1 of the first magnetic layer 31 and the magnetization direction F2 of the second magnetic layer 33 is in the range of 150 degrees to 180 degrees.

A coupling magnetic field is generated between the first magnetic layer 31 and the second magnetic layer 33 by the RKKY interaction. When the element portion 10 formed by stacking the layers illustrated in Fig. 3 is subjected to an annealing process while a magnetic field in the Y1 direction or the Y2 direction is applied to the element portion 10, the magnetization directions F1 and F2 of the first magnetic layer 31 and the second magnetic layer 33 are temporarily oriented in the same direction. However, when the annealing process in the magnetic field is stopped, the magnetization direction F1 of the first magnetic layer 31 and the magnetization direction F2 of the second magnetic layer 33 try to become antiparallel to each other, owing to the coupling magnetic field generated by the RKKY interaction.

Fig. 5 is a graph illustrating the resistance variation rate (ΔR/R) versus the external magnetic field applied to a magnetic detection element according to the present embodiment in the Y1-Y2 direction (sensitivity axis direction). Fig. 5 shows the resistance variation rate (ΔR/R) versus the external magnetic field in the range of -7957.8 A/m (-100 Oe) to +7957.8 A/m (+100 Oe). In Fig. 5, with regard to the external magnetic field, the positive values indicate the external magnetic field in the Y1 direction and the negative values indicate the external magnetic field in the Y2 direction.

In the magnetic detection element illustrated in Fig. 5, the angle [theta] (obtuse angle) between the magnetization direction F1 of the first magnetic layer 31 and the magnetization direction F2 of the second magnetic layer 33 in the magnetic-field-free state (the external magnetic field is 0 A/m (0 Oe)) is about 150 degrees.

When the external magnetic field is increased in the Y1 direction from the magnetic-field-free state (the external magnetic field is 0 A/m (0 Oe)) in Fig. 5, the magnetization direction F1 of the first magnetic layer 31 and the magnetization direction F2 of the second magnetic layer 33 become antiparallel to each other, owing to the external magnetic field and the coupling magnetic field generated by the RKKY interaction. Accordingly, the resistance variation rate (ΔR/R) reaches a maximum value. When the external magnetic field is further increased in the Y1 direction, the antiparallel state is canceled and the magnetization direction F2 of the second magnetic layer 33 rotates from the Y2 direction toward the Y1 direction. Therefore, the magnetization direction F1 of the first magnetic layer 31 and the magnetization direction F2 of the second magnetic layer 33 become closer to parallel, and the resistance variation rate (ΔR/R) gradually decreases.

When the external magnetic field is increased in the Y2 direction from the magnetic-field-free state (the external magnetic field is 0 Oe) in Fig. 5, the magnetization direction F1 of the first magnetic layer 31 and the magnetization direction F2 of the second magnetic layer 33 become antiparallel to each other, owing to the external magnetic field and the coupling magnetic field generated by the RKKY interaction. Accordingly, the resistance variation rate (ΔR/R) reaches a maximum value. When the external magnetic field is further increased in the Y2 direction, the antiparallel state is canceled and the magnetization direction F1 of the first magnetic layer 31 rotates from the Y1 direction toward the Y2 direction. Therefore, the magnetization direction F1 of the first magnetic layer 31 and the magnetization direction F2 of the second magnetic layer 33 become closer to parallel, and the resistance variation rate (ΔR/R) gradually decreases.

As is clear from Fig. 5, the resistance variation rate (ΔR/R) of the magnetic detection element according to the present embodiment is about 14% at a maximum. In the GMR element or an AMR element according to the related art, the resistance variation rate (ΔR/R) is several percent. Therefore, the output can be significantly increased by using the magnetic detection element according to the present embodiment.

In addition, as illustrated in Fig. 5, the waveform of the resistance variation rate (ΔR/R) obtained when the external magnetic field is applied in the Y1 direction and that obtained when the external magnetic field is applied in the Y2 direction are substantially symmetrical to each other about the line at which the external magnetic field is 0 A/m (0 Oe). Therefore, the magnetic sensitivity to the external magnetic field in the Y1 direction is substantially equal to the magnetic sensitivity to the external magnetic field in the Y2 direction. To set the magnetic sensitivities to the external magnetic fields in the Y1 and Y2 directions to be substantially equal to each other, the ratio between Ms1*t1 (Ms is the saturation magnetization and t is the layer thickness) of the first magnetic layer 31 and Ms2*t2 of the second magnetic layer 33 is preferably made as small as possible.

In the present embodiment, (Ms2*t2/Ms1*t1) is preferably greater than 1 and smaller than 2. If the ratio between Ms·t of the first magnetic layer 31 and that of the second magnetic layer 33 is large, the facility of changing (rotating) the magnetization direction differs between the first magnetic layer 31 and the second magnetic layer 33 when the external magnetic field is applied in the Y1 or Y2 direction. In such a case, the waveforms of the resistance variation rate (ΔR/R) versus the external magnetic field applied in the Y1 direction and the external magnetic field applied in the Y2 direction illustrated in Fig. 5 are not horizontally symmetrical to each other. Therefore, the aspect ratio of reconstructed waveforms is not constant and the detection accuracy is reduced. Therefore, to increase the detection accuracy, it is preferable to make the ratio between Ms1·t1 of the first magnetic layer 31 and Ms2·t2 of the second magnetic layer 33 as small as possible.

According to the present embodiment, each element portion 10 included in the magnetic detection element has an oblong shape that extends in the Y1-Y2 direction (sensitivity axis direction). Owing to the shape magnetic anisotropy, the Y1-Y2 direction of the element portion 10 serves as the axial direction in which the element portion 10 can be easily magnetized. Therefore, the resistance of the magnetic detection element does not easily change even when an external magnetic field (disturbance magnetic field) is applied in the X1-X2 direction, which is perpendicular to the Y1-Y2 direction. Thus, the disturbance resistance can be increased.

The relationship between the external magnetic field and the electrical resistance value was determined for the element portions 10 having different aspect ratios.

Each of the element portions 10 used in the experiment included the seed layer 30 [NiFeCr (4.2 nm)], the first magnetic layer 31 (Ni_{B1.5at%}Fe_{18.5}at_{%} (3.0 nm) /Co_{90at%}Fe_{10at%} (1.5 nm)], the non-magnetic layer: Cu (2.0 nm), the second magnetic layer 33 [Co_{90at%}Fe_{10at%} (1.5n m) /Nia_{81.5at%}Fe_{18.5at%} (3.0 nm)], and the protecting layer: Ta (3.0 nm), which are stacked in that order from the bottom. The numerical values in the brackets are the layer thicknesses.

Two to twelve element portions 10 were arranged in the X1-X2 direction as illustrated in Fig. 2 to form a meander shape. The intervals T1 between the element portions 10 were 5 µm.

The length L1 of the element portions 10 in the Y1-Y2 direction (sensitivity axis direction) was set within the range of 200 to 300 µm.

The element width W1 of the element portions 10 in the X1-X2 direction (perpendicular direction) was set to 2 µm (2), 3 µm (2), 4 µm (3), 5 µm (3), 6 µm (4), 7 µm (5), 8 µm (5), 10 µm (6), 15 µm (9), and 20 µm (12). The numbers in the brackets are the numbers of element portions.

In the experiment, the electrical resistance variation was measured while the external magnetic field in the X1-X2 direction (disturbance magnetic field) was applied to the magnetic detection elements having different element widths W1. In addition, the electrical resistance variation was also measured while the external magnetic field was applied to the magnetic detection elements in the Y1-Y2 direction (sensitivity axis direction).

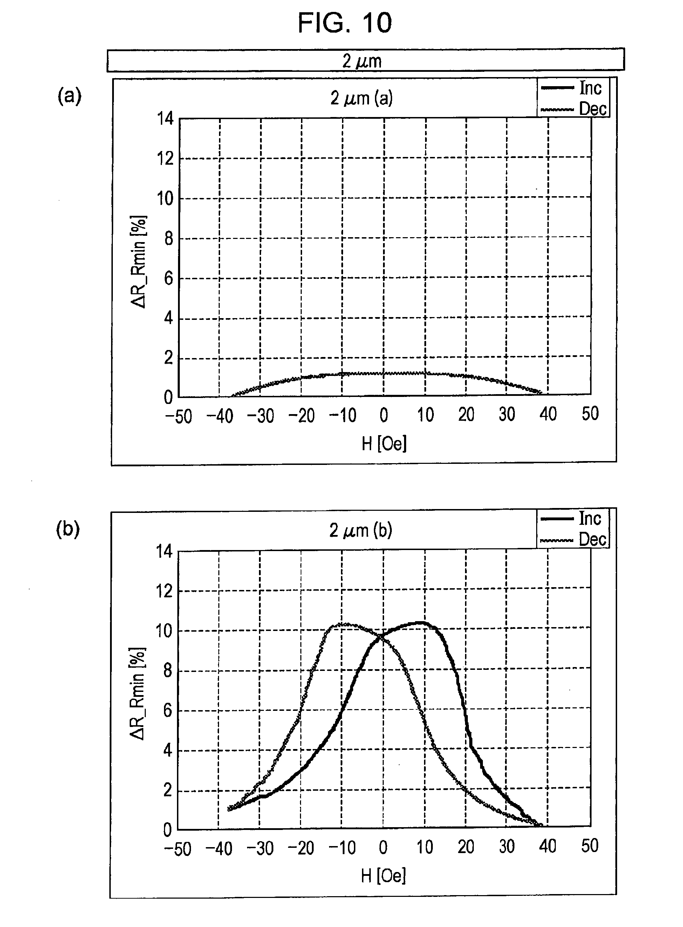

Fig. 10 illustrates the result of the experiment in which the element width W1 was 2 µm (aspect ratio (L1/W1) was 100). In Fig. 10, (a) illustrates the relationship between the external magnetic field in the X1-X2 direction (disturbance magnetic field) and the electrical resistance value, and (b) illustrates the relationship between the external magnetic field in the Y1-Y2 direction (sensitivity axis direction) and the electrical resistance value.

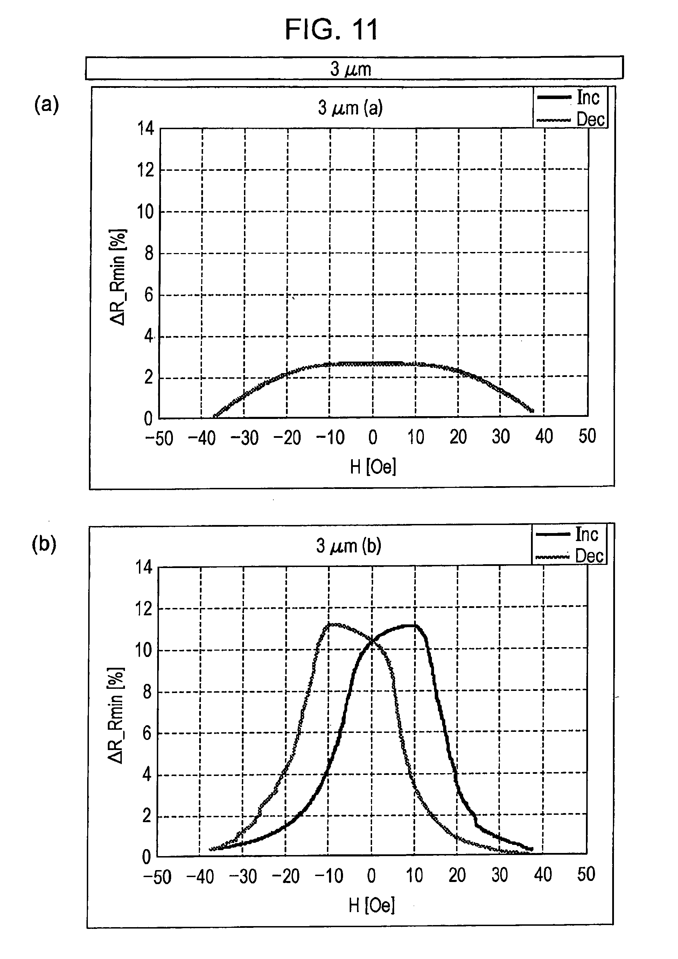

Fig. 11 illustrates the result of the experiment in which the element width W1 was 3 µm (aspect ratio (L1/W1) was 100). In Fig. 11, (a) illustrates the relationship between the external magnetic field in the X1-X2 direction (disturbance magnetic field) and the electrical resistance value, and (b) illustrates the relationship between the external magnetic field in the Y1-Y2 direction (sensitivity axis direction) and the electrical resistance value.

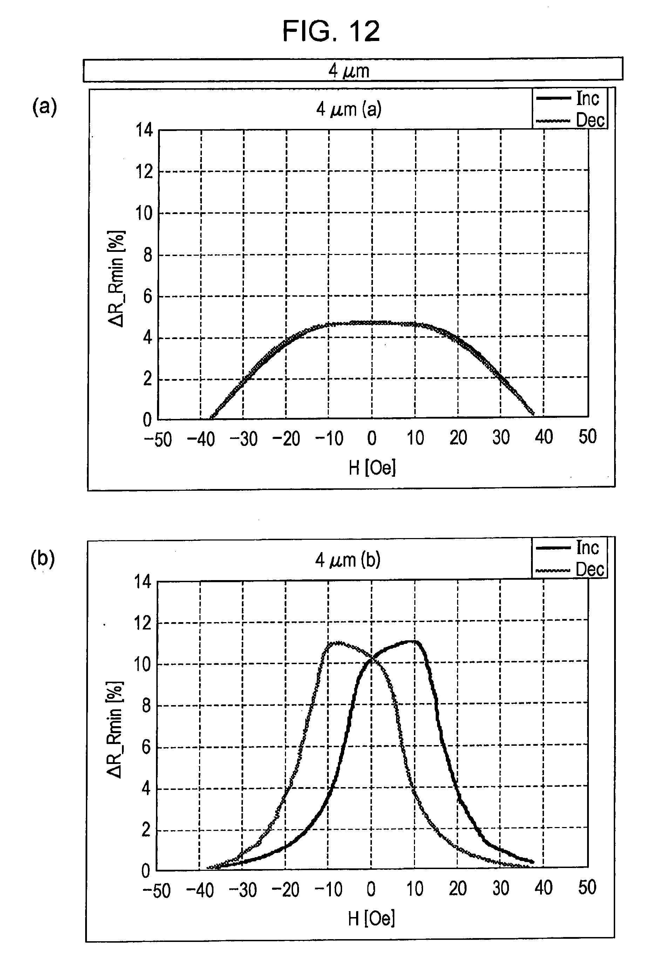

Fig. 12 illustrates the result of the experiment in which the element width W1 was 4 µm (aspect ratio (L1/W1) was 66.7). In Fig. 12, (a) illustrates the relationship between the external magnetic field in the X1-X2 direction (disturbance magnetic field) and the electrical resistance value, and (b) illustrates the relationship between the external magnetic field in the Y1-Y2 direction (sensitivity axis direction) and the electrical resistance value.

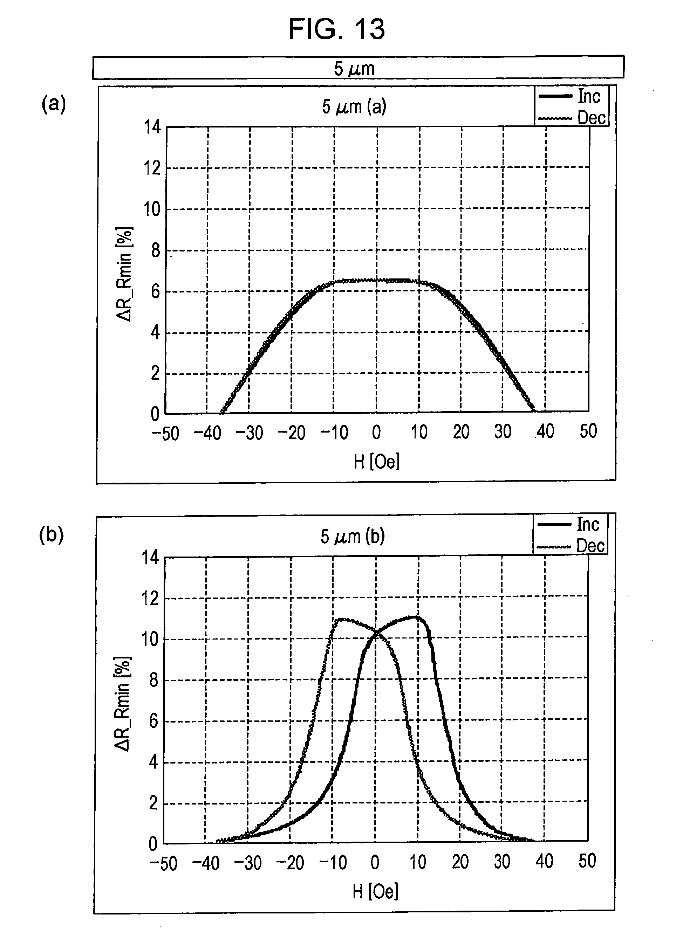

Fig. 13 illustrates the result of the experiment in which the element width W1 was 5 µm (aspect ratio (L1/W1) was 66.7). In Fig. 13, (a) illustrates the relationship between the external magnetic field in the X1-X2 direction (disturbance magnetic field) and the electrical resistance value, and (b) illustrates the relationship between the external magnetic field in the Y1-Y2 direction (sensitivity axis direction) and the electrical resistance value.

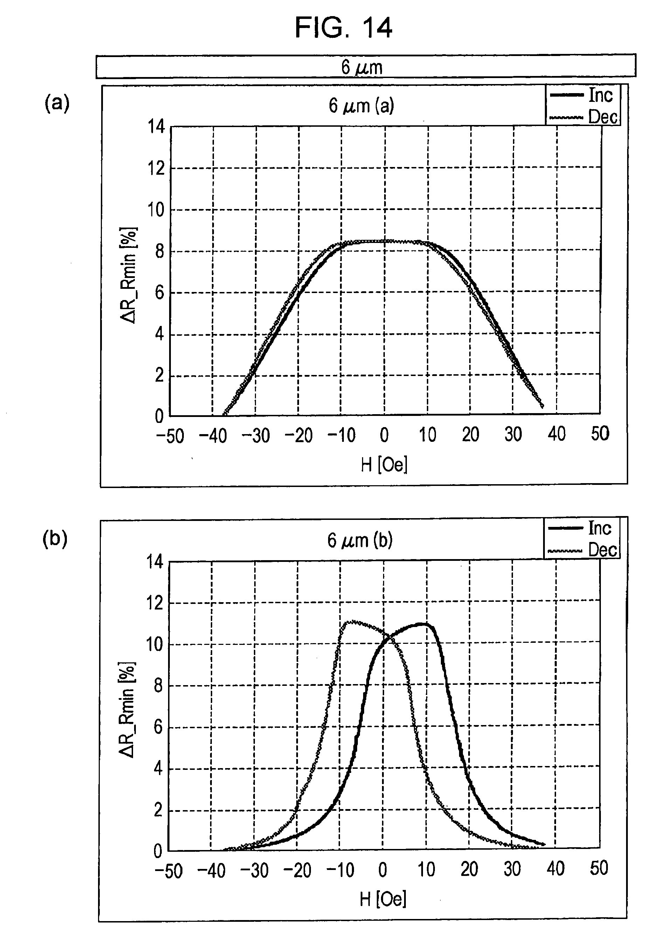

Fig. 14 illustrates the result of the experiment in which the element width W1 was 6 µm (aspect ratio (L1/W1) was 50). In Fig. 14, (a) illustrates the relationship between the external magnetic field in the X1-X2 direction (disturbance magnetic field) and the electrical resistance value, and (b) illustrates the relationship between the external magnetic field in the Y1-Y2 direction (sensitivity axis direction) and the electrical resistance value.

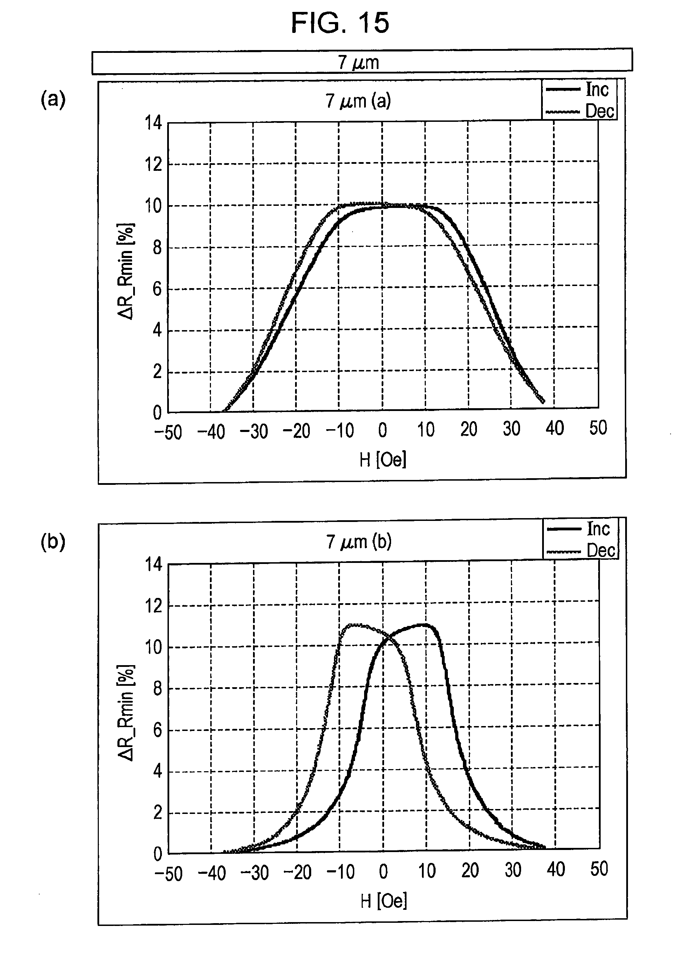

Fig. 15 illustrates the result of the experiment in which the element width W1 was 7 µm (aspect ratio (L1/W1) was 40). In Fig. 15, (a) illustrates the relationship between the external magnetic field in the X1-X2 direction (disturbance magnetic field) and the electrical resistance value, and (b) illustrates the relationship between the external magnetic field in the Y1-Y2 direction (sensitivity axis direction) and the electrical resistance value.

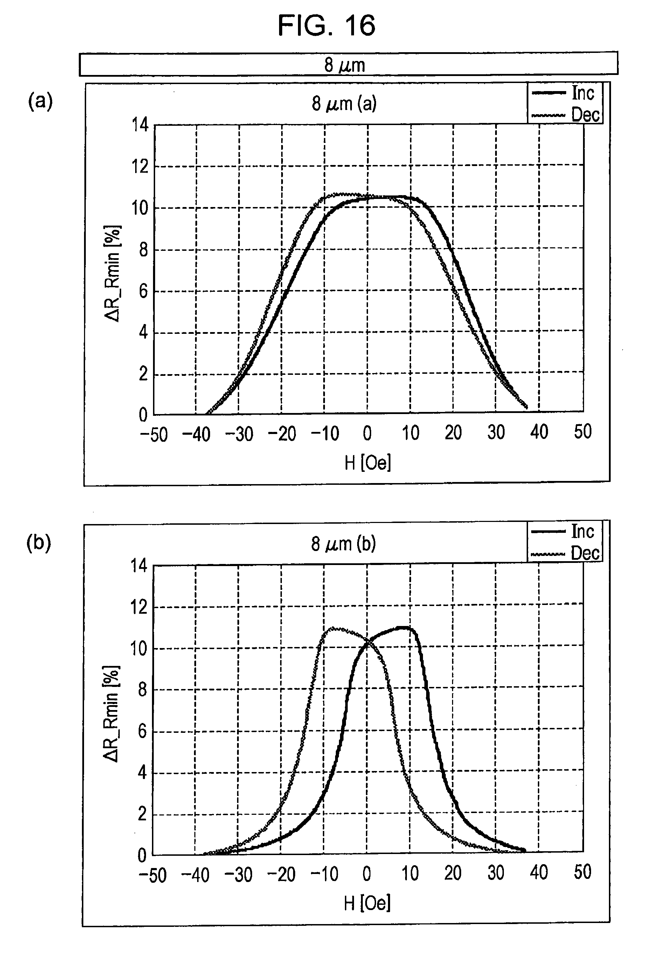

Fig. 16 illustrates the result of the experiment in which the element width W1 was 8 µm (aspect ratio (L1/W1) was 40). In Fig. 16, (a) illustrates the relationship between the external magnetic field in the X1-X2 direction (disturbance magnetic field) and the electrical resistance value, and (b) illustrates the relationship between the external magnetic field in the Y1-Y2 direction (sensitivity axis direction) and the electrical resistance value.

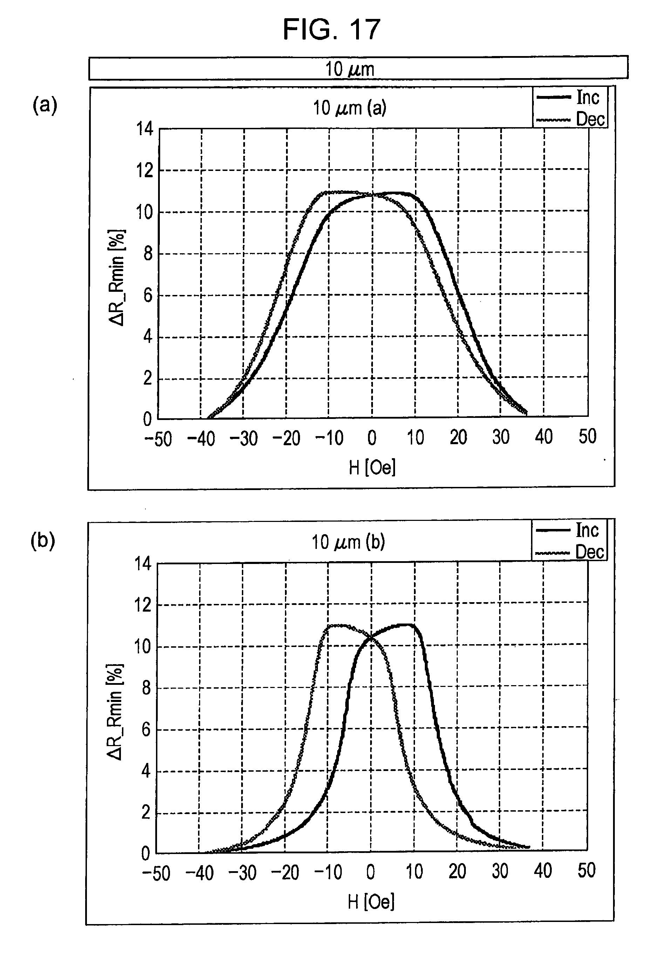

Fig. 17 illustrates the result of the experiment in which the element width W1 was 10 µm (aspect ratio (L1/W1) was 33.3). In Fig. 17, (a) illustrates the relationship between the external magnetic field in the X1-X2 direction (disturbance magnetic field) and the electrical resistance value, and (b) illustrates the relationship between the external magnetic field in the Y1-Y2 direction (sensitivity axis direction) and the electrical resistance value.

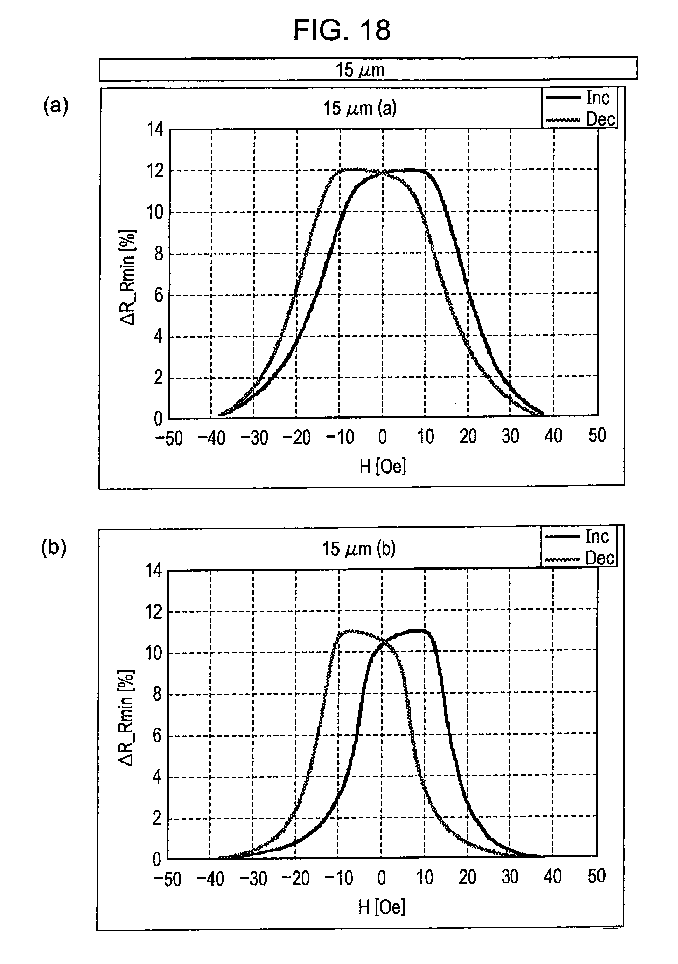

Fig. 18 illustrates the result of the experiment in which the element width W1 was 15 µm (aspect ratio (L1/W1) was 22.2). In Fig. 18, (a) illustrates the relationship between the external magnetic field in the X1-X2 direction (disturbance magnetic field) and the electrical resistance value, and (b) illustrates the relationship between the external magnetic field in the Y1-Y2 direction (sensitivity axis direction) and the electrical resistance value.

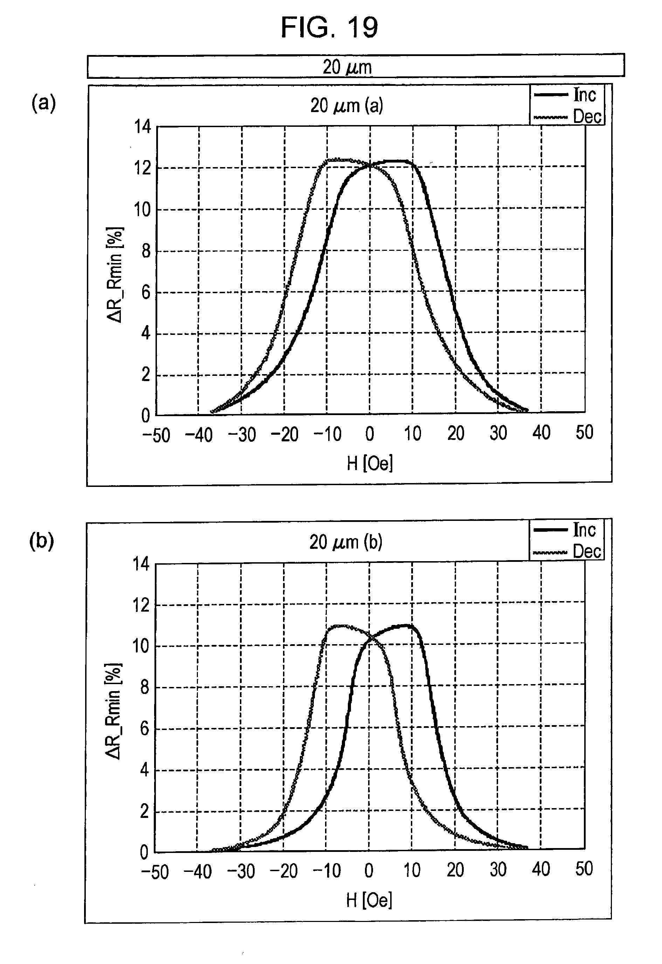

Fig. 19 illustrates the result of the experiment in which the element width W1 was 20 µm (aspect ratio (L1/W1) was 16.7). In Fig. 19, (a) illustrates the relationship between the external magnetic field in the X1-X2 direction (disturbance magnetic field) and the electrical resistance value, and (b) illustrates the relationship between the external magnetic field in the Y1-Y2 direction (sensitivity axis direction) and the electrical resistance value.

As is clear from part (b) of each of Figs. 10 to 19, with regard to the relationship between the external magnetic field in the Y1-Y2 direction (sensitivity axis direction) and the electrical resistance value, the waveforms have substantially the same shape irrespective of the width W1 of the element portions 10.

As is clear from part (a) of each of Figs. 10 to 19, with regard to the relationship between the external magnetic field in the X1-X2 direction (disturbance magnetic field) and the electrical resistance value, as the element width W1 of the element portions 10 increased, the variation in the electrical resistance value in response to the external magnetic field increased. In other words, the disturbance resistance decreased.

The magnetic detection elements according to the present embodiment are provided in the magnetic sensor 22 mounted in the magnetic encoder 20. The magnetic detection elements form bridge circuits illustrated in Fig. 6.

When the magnetic sensor 22 relatively moves in the Y1-Y2 direction, the external magnetic field in the Y1 direction or the Y2 direction is applied to each of the magnetic detection elements A1, A2, B1, and B2 from the magnetized surface (top surface) 21a of the magnet 21. As a result, output waveforms whose phases are shifted from each other by λ/4 are output from the two bridge circuits illustrated in Fig. 6. The movement velocity, the movement distance, and the movement direction of the magnetic sensor 22 or the magnet 21 can be determined on the basis of the output waveforms.

In the case where the magnetic sensor 22 is displaced in the X1 direction or the X2 direction from the center of the magnetized surface 21a of the magnet 21 in the X1-X2 direction, that is, in the width direction, not only the magnetic-field component in the Y1-Y2 direction (sensitivity axis direction) but also the magnetic-field component in the X1-X2 direction (disturbance magnetic-field component) is applied to the magnetic detection elements A1, A2, B1, and B2.

As described above, the magnetic detection elements according to the present embodiment have a satisfactory magnetic sensitivity to the external magnetic-field component in the Y1-Y2 direction (sensitivity axis direction) and a satisfactory disturbance resistance against the magnetic-field component in the X1-X2 direction (disturbance magnetic-field component).

Therefore, compared to the related art, the output can be significantly increased and the deformation of the reconstructed waveforms can be suppressed. Thus, the detection accuracy can be increased.

The arrangement and the bridge circuits of the magnetic detection elements A1, A2, B1, and B2 illustrated in Figs. 1 and 6 are an example.

As illustrated in Fig. 7(a), for example, the magnetic detection elements may be arranged in a matrix pattern, and two bridge circuits illustrated in Fig. 7(b) may be formed using the magnetic detection elements. Each of the eight magnetic detection elements illustrated in Fig. 7(a) has the element structure illustrated in Figs. 2 and 3.

In the magnetic encoder illustrated in Figs. 1, 6, and 7, each bridge circuit outputs two output waveforms in each cycle (λ). This magnetic encoder is called a double-frequency magnetic encoder. The magnetic encoder according to the present embodiment is suitable for use as a double-frequency magnetic encoder.

The bridge circuit structure illustrated in Fig. 8 may also be used. The magnetoresistive elements A1 and the magnetoresistive elements B1 are spaced from each other by λ.

In the above-described magnetic encoder 20, one or both of the magnetic sensor 22 and the magnet 21 linearly move, as illustrated in Fig. 1. However, as illustrated in Fig. 9, the magnetic encoder may include a rotating-drum-type magnet (magnetic-field generating member) 80 having a side surface 80a including sections that are alternately magnetized to N and S poles and a magnetic sensor 22. In this case, the rotational speed, the number of revolutions, and the rotating direction can be determined on the basis of the outputs obtained when the magnet 80 rotates.

The magnetic detection elements according to the present embodiment may be used in magnetic sensors other than those included in the magnetic encoders.

For example, the magnetic detection elements may be applied to a geomagnetism sensor. In such a case, the Y1-Y2 direction (sensitivity axis direction) is set as the direction of geomagnetism.

### Brief Description of Drawings

[Fig. 1] Fig. 1 is a partial perspective view of a magnetic encoder according to the present embodiment.
[Fig. 2] Fig. 2 is an enlarged plan view of a magnetic detection element included in a magnetic sensor.
[Fig. 3] Fig. 3 is a partial enlarged sectional view of the magnetic detection element illustrated in Fig. 2 taken along line A-A and viewed in a direction shown by the arrows.
[Fig. 4] Fig. 4 is a schematic plan view illustrating the relationship between magnetization of a first magnetic layer and magnetization of a second magnetic layer.
[Fig. 5] Fig. 5 is a graph illustrating the relationship between the external magnetic field in the sensitivity axis direction and the resistance variation rate (ΔR/R) in the magnetic detection element according to the present embodiment.
[Fig. 6] Fig. 6 is a circuit diagram of the magnetic sensor according to the present embodiment.
[Fig. 7] (a) is a diagram illustrating the arrangement of magnetic detection elements that differs from the arrangement in Fig. 1, and (b) is a circuit diagram of a circuit including the magnetic detection elements illustrated in Fig. 7(a).
[Fig. 8] Fig. 8 is a circuit diagram of a magnetic sensor according to the present embodiment that differs from the magnetic sensor illustrated in Figs. 6 and 7.
[Fig. 9] Fig. 9 is a partial side view of a magnetic encoder according to the present embodiment having a structure that differs from the structure illustrated in Fig. 1.
[Fig. 10] Fig. 10 illustrates the result of the experiment in which the element width W1 was 2 µm where (a) is a graph of the relationship between the external magnetic field in the X1-X2 direction (disturbance magnetic field) and the electrical resistance value and (b) is a graph of the relationship between the external magnetic field in the Y1-Y2 direction (sensitivity axis direction) and the electrical resistance value.
[Fig. 11] Fig. 11 illustrates the result of the experiment in which the element width W1 was 3 µm, where (a) is a graph of the relationship between the external magnetic field in the X1-X2 direction (disturbance magnetic field) and the electrical resistance value and (b) is a graph of the relationship between the external magnetic field in the Y1-Y2 direction (sensitivity axis direction) and the electrical resistance value.
[Fig. 12] Fig. 12 illustrates the result of the experiment in which the element width W1 was 4 µm, where (a) is a graph of the relationship between the external magnetic field in the X1-X2 direction (disturbance magnetic field) and the electrical resistance value and (b) is a graph of the relationship between the external magnetic field in the Y1-Y2 direction (sensitivity axis direction) and the electrical resistance value.
[Fig. 13] Fig. 13 illustrates the result of the experiment in which the element width W1 was 5 µm, where (a) is a graph of the relationship between the external magnetic field in the X1-X2 direction (disturbance magnetic field) and the electrical resistance value and (b) is a graph of the relationship between the external magnetic field in the Y1-Y2 direction (sensitivity axis direction) and the electrical resistance value.
[Fig. 14] Fig. 14 illustrates the result of the experiment in which the element width W1 was 6 µm, where (a) is a graph of the relationship between the external magnetic field in the X1-X2 direction (disturbance magnetic field) and the electrical resistance value and (b) is a graph of the relationship between the external magnetic field in the Y1-Y2 direction (sensitivity axis direction) and the electrical resistance value.
[Fig. 15] Fig. 15 illustrates the result of the experiment in which the element width W1 was 7 µm, where (a) is a graph of the relationship between the external magnetic field in the X1-X2 direction (disturbance magnetic field) and the electrical resistance value and (b) is a graph of the relationship between the external magnetic field in the Y1-Y2 direction (sensitivity axis direction) and the electrical resistance value.
[Fig. 16] Fig. 16 illustrates the result of the experiment in which the element width W1 was 8 µm, where (a) is a graph of the relationship between the external magnetic field in the X1-X2 direction (disturbance magnetic field) and the electrical resistance value and (b) is a graph of the relationship between the external magnetic field in the Y1-Y2 direction (sensitivity axis direction) and the electrical resistance value.
[Fig. 17] Fig. 17 illustrates the result of the experiment in which the element width W1 was 10 µm, where (a) is a graph of the relationship between the external magnetic field in the X1-X2 direction (disturbance magnetic field) and the electrical resistance value and (b) is a graph of the relationship between the external magnetic field in the Y1-Y2 direction (sensitivity axis direction) and the electrical resistance value.
[Fig. 18] Fig. 18 illustrates the result of the experiment in which the element width W1 was 15 µm, where (a) is a graph of the relationship between the external magnetic field in the X1-X2 direction (disturbance magnetic field) and the electrical resistance value and (b) is a graph of the relationship between the external magnetic field in the Y1-Y2 direction (sensitivity axis direction) and the electrical resistance value.
[Fig. 19] Fig. 19 illustrates the result of the experiment in which the element width W1 was 20 µm, where (a) is a graph of the relationship between the external magnetic field in the X1-X2 direction (disturbance magnetic field) and the electrical resistance value and (b) is a graph of the relationship between the external magnetic field in the Y1-Y2 direction (sensitivity axis direction) and the electrical resistance value.
[Fig. 20] (a) is a plan view illustrating the state in which a GMR element is placed above a magnetized surface of a magnet at a center CL of the magnetized surface in the width direction thereof, and (b) is a graph illustrating the resistance variation along the direction of relative movement of the GMR element from the initial position (0).
[Fig. 21] (a) is a plan view illustrating the state in which the GMR element is placed above the magnetized surface of the magnet at a position shifted from the center CL of the magnetized surface in the width direction thereof, and (b) is a graph illustrating the resistance variation along the direction of relative movement of the GMR element from the initial position (0).

### Reference Numerals

- 10: element portion
- 11: connecting portion
- 20: magnetic encoder
- 21, 80: magnet
- 21a: top surface (magnetized surface) (of magnet)
- 22: magnetic sensor
- 23: substrate
- 30: seed layer
- 31: first magnetic layer
- 32: non-magnetic layer
- 33: second magnetic layer
- 34: protecting layer
- 35, 38: Ni-Fe layer
- 36, 37: Co-Fe layer
- 80a: side surface (magnetized surface) (of magnet)
- A1, A2, B1, and B2: magnetic detection element
- F1, F2: magnetization direction

## Claims

1. A magnetic sensor (22) comprising a magnetic detection element (A1, A2, B1, B2) having an electrical resistance value that varies in accordance with an external magnetic field in a sensitivity axis direction,
wherein the magnetic detection element (A1, A2, B1, B2) includes an element portion (10) having a layered structure in which a first magnetic layer (31) and a second magnetic layer (33) are stacked with a non-magnetic layer (32) interposed therebetween,
wherein the first magnetic layer (31) and the second magnetic layer (33) are not pinned and the magnetization of each of the first magnetic layer (31) and the second magnetic layer (33) is variable in accordance with the external magnetic field,
wherein, in a magnetic-field-free state, a magnetization direction of the first magnetic layer (31) is inclined from an element width direction (X1-X2) that is perpendicular to the sensitivity axis direction (Y1-Y2) toward a first direction along the sensitivity axis direction (Y1-Y2) and a magnetization direction of the second magnetic layer (33) is inclined from the element width direction (X1-X2) toward a second direction that is opposite to the first direction along the sensitivity axis direction (Y1-Y2), an angle between the magnetization direction of the first magnetic layer (31) and the magnetization direction of the second magnetic layer(33) being in the range of 90 degrees to 180 degrees
wherein the element portion (10) has an oblong shape, a longitudinal direction of the element portion (10) extending in the sensitivity axis direction (Y1-Y2), and
wherein a resistance variation rate curve with respect to magnetic field variation in the sensitivity axis direction (Y1-Y2) of the element portion (10) is substantially symmetrical with respect to a magnetic field-free state.

2. The magnetic sensor (22) according to Claim 1, wherein the magnetization direction of the first magnetic layer (31) and the magnetization direction of the second magnetic layer (33) are substantially antiparallel to each other along a direction parallel to the sensitivity axis direction (Y1-Y2).

3. The magnetic sensor (22) according to Claim 1 or 2, wherein a ratio between the magnetic moment Ms1*t1, wherein Ms is a saturation magnetization and t is a layer thickness, of the first magnetic layer (31) and the magnetic moment Ms2*t2 of the second magnetic layer (33) (Ms2*t2/Ms1*t1) is greater than 1 and smaller than 2.

4. The magnetic sensor (22) according to Claim 1 or 2, wherein each of the first magnetic layer (31) and the second magnetic layer (33) has a layered structure including a Co-Fe layer (36, 37) and a Ni-Fe layer (35, 38), and the Co-Fe (36, 37) layers of the first and second magnetic layers (31, 33) are opposed to each other with the non- magnetic layer (32) interposed therebetween.

5. The magnetic sensor (22) according to one of Claims 1 to 4, wherein the magnetic detection element (A1, A2, B1, B2) includes a plurality of the element portions (10) that are arranged with intervals therebetween in a direction perpendicular to the sensitivity axis direction (Y1-Y2), the element portions (10) being shaped so as to be connected to each other at the ends of the element portions (10) in the sensitivity axis direction (Y1-Y2).

6. A magnetic encoder (20) comprising the magnetic sensor (22) according to one of Claims 1 to 5 and a magnetic-field generating member (21; 80) having a magnetized surface (21a; 80a) including sections that are alternately magnetized to N and S poles along a relative movement direction, which is the sensitivity axis direction (Y1-Y2), wherein the magnetic sensor (22) is disposed at a position spaced from the magnetized surface in a height direction.

## Patentansprüche

1. Magnetsensor (22), der ein magnetisches Erfassungselement (A1, A2, B1, B2) mit einem elektrischen Widerstandswert aufweist, der in Abhängigkeit von einem externen Magnetfeld in einer Empfindlichkeitsachsenrichtung variiert, wobei das magnetische Erfassungselement (A1, A2, B1, B2) einen Element bereich (10) mit einer Schichtstruktur aufweist, in der eine erste magnetische Schicht (31) und eine zweite magnetische Schicht (33) mit einer nicht-magne tischen Schicht (32) dazwischen aufeinander gestapelt sind,
wobei die erste magnetische Schicht (31) und die zweite magnetische Schicht (33) nicht fixiert sind und die Magnetisierung von jeder der ersten magnetischen Schicht (31) und der zweiten magnetischen Schicht (33) in Abhängigkeit von dem externen Magnetfeld variabel ist,
wobei in einem magnetfeldfreien Zustand eine Magnetisierungsrichtung der ersten magnetischen Schicht (31) von einer Element-Breitenrichtung (X1-X2), die senkrecht zu der Empfindlichkeitsachsenrichtung (Y1-Y2) ist, in Richtung einer ersten Richtung entlang der Empfindlichkeitsachsenrichtung (Y1-Y2) geneigt ist und eine Magnetisierungsrichtung der zweiten Magnetschicht (33) von der Element-Breitenrichtung (X1-X2) in Richtung einer zu der ersten Richtung entgegengesetzten zweiten Richtung entlang der Empfind lichkeitsachsenrichtung (Y1-Y2) geneigt ist, wobei ein Winkel zwischen der Magnetisierungsrichtung der ersten magnetischen Schicht (31) und der Magnetisierungsrichtung der zweiten magnetischen Schicht (33) in dem Bereich von 90 Grad bis 180 Grad liegt,
wobei der Elementbereich (10) eine längliche Form aufweist, wobei eine Längsrichtung des Elementbereichs (10) in der Empfindlichkeitsachsenrichtung verläuft, und
wobei eine Widerstandsänderungsraten-Kurve bezogen auf die Magnetfeldänderung in der Empfindlichkeitsachsenrichtung (Y1-Y2) des Elementbereichs (10) in Bezug auf einen magnetfeldfreien Zustand im Wesentlichen symmetrisch ist.

2. Magnetsensor (22) nach Anspruch 1,
wobei die Magnetisierungsrichtung der ersten magnetischen Schicht (31) und die Magnetisierungsrichtung der zweiten magnetischen Schicht (33) im Wesentlichen antiparallel zueinander entlang einer Richtung parallel zu der Emp findlichkeitsachsenrichtung (Y1-Y2) sind.

3. Magnetsensor (22) nach Anspruch 1 oder 2,
wobei ein Verhältnis zwischen dem magnetischen Moment Ms1*t1, wobei Ms eine Sättigungsmagnetisierung ist und t eine Schichtdicke ist, der ersten magnetischen Schicht (31) und dem magnetischen Moment Ms2*t2 der zweiten magnetischen Schicht (33) (Ms2*t2 /Ms1*t1) größer als 1 und kleiner als 2 ist.

4. Magnetsensor (22) nach Anspruch 1 oder 2,
wobei jede der ersten magnetischen Schicht (31) und der zweiten magnetischen Schicht (33) eine Schichtstruktur aufweist, die eine Co-Fe-Schicht (36, 37) und eine Ni-Fe-Schicht (35, 38) beinhaltet, und wobei die Co-Fe-Schichten (36, 37) der ersten und zweiten magnetischen Schicht (31, 33) unter Zwischenanordnung der nichtmagnetischen Schicht (32) einander gegenüberliegen.

5. Magnetsensor (22) nach einem derAnsprüche 1 bis 4,
wobei das magnetische Erfassungselement (A1, A2, B1, B2) eine Mehrzahl der Elementbereiche (10) aufweist, die mit Abständen dazwischen in einer Richtung senkrecht zu der Empfindlichkeitsachsenrichtung (Y1-Y2) angeordnet sind, wobei die Elementbereiche (10) derart geformt sind, dass sie an den Enden der Elementbereiche (10) in der Empfindlichkeitsachsenrichtung Y-Y) miteinander verbunden sind.

6. Magnetischer Kodierer (20), der den Magnetsensor (22) gemäß einem der Ansprüche 1 bis 5 und ein Magnetfelderzeugungselement (21; 80) mit einer magnetisierten Oberfläche (21a; 80a) aufweist, die Abschnitte beinhaltet, die entlang einer Relativbewegungsrichtung, bei der es sich um die Empfindlich keitsachsenrichtung (Y1-Y2) handelt, abwechselnd zu N- und S-Polen magnetisiert sind, wobei der Magnetsensor (22) an einer Position angeordnet ist, die von der magnetisierten Oberfläche in einer Höhenrichtung beabstandet ist.

## Revendications

1. Capteur magnétique (22) comprenant un élément de détection magnétique (A1, A2, B1, B2) ayant une valeur de résistance électrique qui varie en fonction d'un champ magnétique extérieur dans une direction d'axe de sensibilité,
dans lequel l'élément de détection magnétique (A1, A2, B1, B2) comprend une portion d'élément (10) ayant une structure en couches dans laquelle une première couche magnétique (31) et une deuxième couche magnétique (33) sont empilées avec une couche non magnétique (32) intercalée entre elles,
dans lequel la première couche magnétique (31) et la deuxième couche magnétique (33) ne sont pas bloquées et la magnétisation de chacune des première couche magnétique (31) et deuxième couche magnétique (33) est variable en fonction du champ magnétique extérieur,
dans lequel, dans un état exempt de champ magnétique, une direction de magnétisation de la première couche magnétique (31) est inclinée d'une direction de largeur d'élément (X1-X2) qui est perpendiculaire à la direction d'axe de sensibilité (Y1-Y2) vers une première direction le long de la direction d'axe de sensibilité (Y1-Y2) et une direction de magnétisation de la deuxième couche magnétique (33) est inclinée de la direction de largeur d'élément (X1-X2) vers une deuxième direction qui est opposée à la première direction le long de la direction d'axe de sensibilité (Y1-Y2), un angle entre la direction de magnétisation de la première couche magnétique (31) et la direction de magnétisation de la deuxième couche magnétique (33) étant compris dans la plage de 90 degrés à 180 degrés,
dans lequel la portion d'élément (10) a une forme oblongue, une direction longitudinale de la portion d'élément (10) s'étendant dans la direction d'axe de sensibilité (Y1-Y2), et
dans lequel une courbe de taux de variation de résistance par rapport à la variation de champ magnétique dans la direction d'axe de sensibilité (Y1-Y2) de la portion d'élément (10) est substantiellement symétrique par rapport à un état exempt de champ magnétique.

2. Capteur magnétique (22) selon la revendication 1, dans lequel la direction de magnétisation de la première couche magnétique (31) et la direction de magnétisation de la deuxième couche magnétique (33) sont substantiellement antiparallèles entre elles le long d'une direction parallèle à la direction d'axe de sensibilité (Y1-Y2).

3. Capteur magnétique (22) selon la revendication 1 ou 2, dans lequel le rapport entre le moment magnétique Ms1*t1, dans lequel Ms est une magnétisation de saturation et t est une épaisseur de couche, de la première couche magnétique (31) et le moment magnétique Ms2*t2 de la deuxième couche magnétique (33) (Ms2*t2/Ms1*t1) est supérieur à 1 et inférieur à 2.

4. Capteur magnétique (22) selon la revendication 1 ou 2, dans lequel chacune des première couche magnétique (31) et deuxième couche magnétique (33) a une structure en couches comportant une couche de Co-Fe (36, 37) et une couche de Ni-Fe (35, 38), et les couches de Co-Fe (36, 37) des première et deuxième couches magnétiques (31, 33) sont opposées l'une à l'autre, avec la couche non magnétique (32) intercalée entre elles.

5. Capteur magnétique (22) selon l'une des revendications 1 à 4, dans lequel l'élément de détection magnétique (A1, A2, B1, B2) comprend une pluralité des portions d'élément (10) qui sont agencées avec des intervalles entre elles dans une direction perpendiculaire à la direction d'axe de sensibilité (Y1-Y2), les portions d'élément (10) ayant une forme qui leur permet d'être connectées entre elles aux extrémités des portions d'élément (10) dans la direction d'axe de sensibilité (Y1-Y2).

6. Codeur magnétique (20) comprenant le capteur magnétique (22) de l'une des revendications 1 à 5 et un élément générant un champ magnétique (21 ; 80) ayant une surface magnétisée (21a ; 80a) qui comporte des sections magnétisées alternativement avec des pôles N et S le long d'une direction de déplacement relatif, qui est la direction d'axe de sensibilité (Y1-Y2), dans lequel le capteur magnétique (22) est placé en une position distante de la surface magnétisée dans une direction de hauteur.
